# FASCICULE DE BREVET EUROPEEN

(11) **EP 3 584 164 B1**
(45) Date de publication et mention de la délivrance du brevet: **11.11.2020**
(21) Numéro de dépôt: 19180220.6
(22) Date de dépôt: 14.06.2019
(51) Int. Cl.: B64D 11/00

(54) **AÉRONEF COMPRENANT UN CHÂSSIS TRANSVERSAL DESTINÉ À UNE SOUTE AVIONIQUE**
LUFTFAHRZEUG, DAS EINEN QUERRAHMEN FÜR EINEN FLUGZEUGFRACHTRAUM UMFASST
AIRCRAFT INCLUDING A TRANSVERSE FRAME INTENDED FOR AN AVIONICS HOLD

(30) Priorité: 20.06.2018 FR 1855444
(43) Date de publication de la demande: 25.12.2019
(73) Titulaire: AIRBUS OPERATIONS (S.A.S.), 31060 Toulouse (FR)
(72) Inventeur: GUERING, Bernard, 31060 TOULOUSE Cedex 9 (FR); SAINT-MARC, Laurent, 31060 TOULOUSE Cedex 9 (FR)
(74) Mandataire: Gicquel, Olivier Yves Gérard

(56) Documents cités:
- EP-A1- 3 091 270
- US-A1- 2003 155 319
- US-A1- 2012 062 084

## Description

La présente demande se rapporte à un aéronef comprenant un châssis transversal destiné à une soute avionique.

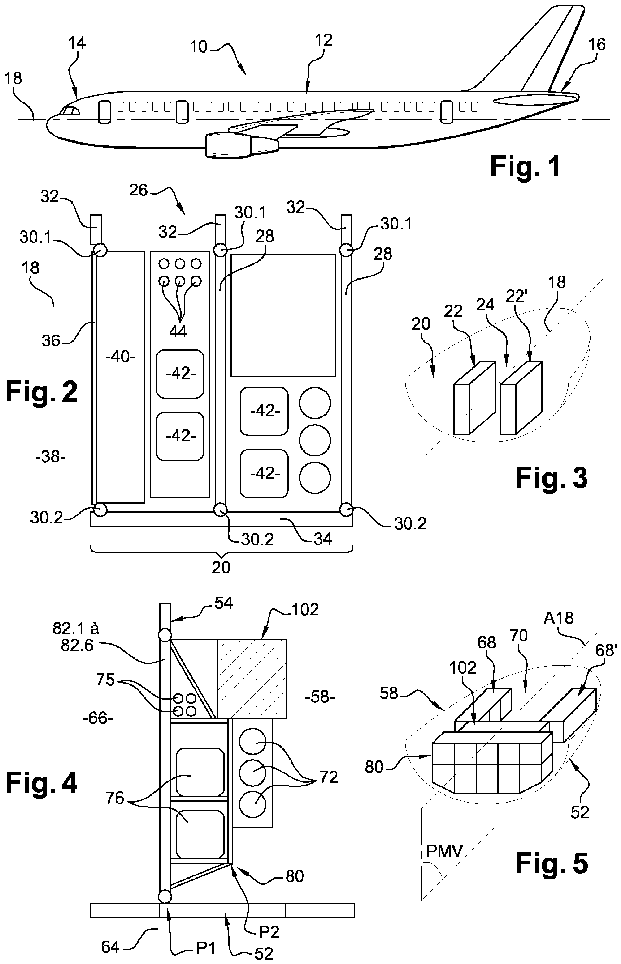

Sur la figure 1, on a représenté un aéronef 10 comprenant un fuselage 12, formé de plusieurs tronçons disposés bout à bout, qui s'étend entre une pointe avant 14 correspondant au tronçon situé le plus à l'avant et une pointe arrière 16 correspondant au tronçon situé le plus à l'arrière.

Pour la suite de la description, un axe longitudinal 18 de l'aéronef 10 correspond à l'axe horizontal, lorsque l'aéronef 10 est au sol, qui s'étend de la pointe avant 14 à la pointe arrière 16 de l'aéronef 10. Une direction longitudinale est une direction parallèle à l'axe longitudinal 18. Un plan longitudinal est un plan qui est parallèle à l'axe longitudinal 18. Un plan transversal est un plan perpendiculaire à l'axe longitudinal 18.

Comme tous les tronçons, la pointe avant 14 comprend une structure primaire qui comporte des raidisseurs transversaux appelés cadres, des raidisseurs longitudinaux appelés lisses et une peau qui forme l'enveloppe extérieure de l'aéronef. La pointe avant 14 comprend un plancher relié à la structure primaire qui divise la pointe avant en deux zones, une zone supérieure qui correspond à une cabine de pilotage et une zone inférieure qui correspond à une soute avionique. La pointe avant 14 comprend également une structure secondaire qui comporte des panneaux qui cloisonnent et recouvrent l'intérieur de la structure primaire et différents équipements, accessoires, meubles qui sont reliés à la structure primaire.

Selon une technique d'assemblage décrite dans le document FR-3.051.176, le plancher et les éléments secondaires situés au-dessus du plancher de la pointe avant sont assemblés de manière à former un module d'assemblage autoporteur qui est introduit et immobilisé dans la structure primaire. Le module d'assemblage autoporteur est assemblé et équipé des différents éléments de la structure secondaire concomitamment à l'assemblage de la structure primaire. Ainsi, le montage des éléments de la structure secondaire est réalisé en temps masqué ce qui contribue à améliorer la cadence d'assemblage des aéronefs. Suite à la mise en place du module d'assemblage autoporteur, la soute avionique située sous le plancher est équipée.

Selon une configuration décrite dans le document FR.3.000.030 et schématisée sur la figure 3, une soute avionique 20 comprend deux rangées de meubles avioniques 22, 22', 26, parallèles à l'axe longitudinal 18, disposées de part et d'autre d'un unique couloir 24 et de manière symétrique par rapport à un plan longitudinal médian vertical PMV. Ainsi, chaque rangée comprend au moins un meuble avionique avant, dans lequel sont agencés un cœur électrique et des éléments complémentaires au cœur électrique, et au moins un meuble avionique arrière 26, visible sur la figure 2.

Chaque meuble avionique arrière 26, disposé de part et d'autre de l'unique couloir 24, comprend une structure porteuse 28, reliée, en partie supérieure, au plancher 32 au niveau de plusieurs points de liaison 30.1 et, en partie inférieure, à la structure primaire 34 de la pointe avant 14 au niveau de plusieurs points de liaison 30.2. Chaque meuble avionique arrière 26 comprend, à l'arrière, une cloison d'étanchéité et de surpression 36 délimitant la soute avionique 20 et la soute à bagages 38 ; et à l'avant de la cloison d'étanchéité et de surpression 36, une zone de rétention 40 destinée à la reprise des efforts en cas de désarrimage d'un conteneur dans la soute à bagages 38. Chaque meuble avionique arrière 26 assure la fonction de support et comprend des compartiments dans lesquels sont positionnés des équipements 42 comme des batteries ou des centrales inertielles. Les meubles avioniques arrière 26 disposés de part et d'autre du couloir assurent la fonction de support pour des routes électriques 44 transversales et des canalisations de fluide 46 transversales.

Cet agencement de la soute avionique n'est pas pleinement satisfaisant car il n'est pas optimal sur le plan de la compacité.

La présente invention vise à remédier à tout ou partie des inconvénients de l'art antérieur.

A cet effet, l'invention a pour objet un aéronef comprenant une soute avionique séparée d'une deuxième soute par une frontière arrière et un châssis transversal pour la soute avionique, ladite soute avionique étant délimitée par une structure primaire et un plancher, caractérisé en ce que le châssis transversal comprend :
- des bielles verticales, positionnées dans un premier plan transversal, qui comprennent chacune, à une extrémité supérieure, une première connexion configurée pour être reliée à un point d'ancrage prévu au niveau du plancher et, à une extrémité inférieure, une deuxième connexion configurée pour être reliée à un point d'ancrage prévu au niveau de la structure primaire,
- des premières traverses horizontales, reliant les bielles deux à deux, positionnées dans le premier plan transversal,
- des montants verticaux, positionnés dans un deuxième plan transversal espacé du premier plan transversal,
- des deuxièmes traverses horizontales, reliant les montants deux à deux, positionnées dans le deuxième plan transversal,
- des longerons, horizontaux et orientés perpendiculairement au premier plan transversal, reliant les bielles et les montants deux à deux,
- les bielles, les montants, les premières et deuxièmes traverses et les longerons étant agencés de manière à ce que le châssis transversal forme une structure à mailles carrées et/ou rectangulaires.

Ce châssis transversal permet d'optimiser l'encombrement de la soute avionique, une partie du couloir prévue entre les meubles avioniques longitudinaux de l'art antérieur étant occupée par le châssis transversal. Selon cette configuration, tous les équipements de la soute avionique sont accessibles depuis la zone de dégagement ou depuis la soute à bagages. L'optimisation de l'encombrement de la soute avionique permet d'augmenter le volume de la soute à bagages.

Selon une autre caractéristique, au moins certaines mailles du châssis transversal comprennent des renforts obliques de manière à obtenir une structure en treillis.

Selon une configuration, au moins certains des renforts obliques sont disposés au niveau de mailles verticales longitudinales et sont inclinés vers le bas et vers le premier plan transversal.

Selon une autre caractéristique, le châssis transversal comprend des suspentes inclinées, chacune d'elles reliant l'extrémité supérieure d'une bielle et un montant.

Selon une configuration, les longerons et les premières et deuxièmes traverses disposés dans un même plan horizontal, le plus haut, forment un support horizontal haut et certaines des suspentes inclinées sont reliées aux montants de manière à dégager une partie du support horizontal haut orientée vers le deuxième plan transversal.

Selon une autre caractéristique, le châssis transversal comprend au moins une tablette positionnée au niveau d'au moins une des mailles horizontales et formant une étagère.

Selon une configuration, le châssis transversal comprend au moins une liaison glissière reliant un équipement et le châssis transversal, configurée pour permettre au dit équipement de se translater selon une direction perpendiculaire au premier plan transversal par rapport au châssis transversal.

Selon un mode de réalisation, les premières et deuxièmes traverses disposées entre deux plans longitudinaux verticaux consécutifs sont démontables de manière à scinder le châssis transversal en deux sous-ensembles.

L'invention a également pour objet un module d'assemblage destiné à être inséré dans une structure primaire d'une pointe avant d'un aéronef comprenant un plancher, une structure secondaire supérieure et un châssis transversal selon l'une des caractéristiques précédentes.

L'invention a également pour objet un aéronef comprenant une soute avionique séparée d'une deuxième soute par une frontière arrière ainsi qu'un châssis transversal selon l'invention, le premier plan transversal du châssis transversal étant positionné perpendiculairement à une direction longitudinale de l'aéronef, au niveau de la frontière arrière.

Selon une autre caractéristique, le châssis transversal comprend une cloison d'étanchéité et de surpression prenant appui contre les bielles et assurant une étanchéité entre la soute avionique et la deuxième soute, ladite cloison d'étanchéité et de surpression comprenant au moins une ouverture et pour chaque ouverture un panneau de surpression configuré pour occuper un état repos dans lequel le panneau de surpression obture l'ouverture et un état détaché après une surpression dans lequel le panneau de surpression dégage au moins partiellement l'ouverture.

Selon un mode de réalisation, la cloison d'étanchéité et de surpression comprend une ouverture pour chaque maille verticale transversale située au niveau du premier plan transversal et pour chaque zone située entre les bielles, au-dessus des premières traverses les plus hautes.

Selon un agencement, la soute avionique comprend deux rangées longitudinales de meubles avioniques, parallèles à la direction longitudinale et disposés de part et d'autre d'une zone de dégagement, un meuble avionique transversal supporté par le châssis transversal situé à l'arrière des deux rangées longitudinales de meubles avioniques.

D'autres caractéristiques et avantages ressortiront de la description de l'invention qui va suivre, description donnée à titre d'exemple uniquement, en regard des dessins annexés parmi lesquels :
- la figure 1 est une vue latérale d'un aéronef,
- la figure 2 est une représentation schématique en vue de dessus d'un meuble avionique arrière qui illustre un mode de réalisation d'un agencement de l'art antérieur,
- la figure 3 est une représentation schématique en perspective de meubles avioniques positionnés dans une soute avionique qui illustre un agencement de l'art antérieur,
- la figure 4 est une coupe schématique transversale d'un châssis transversal qui illustre un mode de réalisation de l'invention,
- la figure 5 est une représentation schématique en perspective de meubles avioniques et d'un châssis transversal positionnés dans une soute avionique d'un aéronef qui illustre un agencement de l'invention,
- la figure 6 est une vue en perspective d'un châssis transversal qui illustre un mode de réalisation de l'invention,
- la figure 7 est une vue latérale du châssis transversal visible sur la figure 6,
- la figure 8 est une vue de face du châssis transversal visible sur la figure 6,
- la figure 9 est une vue en perspective du châssis transversal, visible sur la figure 6, positionné sous un plancher d'une pointe avant d'un aéronef,
- la figure 10 est une vue en perspective, depuis l'arrière, du châssis transversal visible sur la figure 6 supportant une partie de ses équipements,
- la figure 11 est une vue en perspective, depuis l'avant, du châssis transversal visible sur la figure 6 supportant une partie de ses équipements,
- la figure 12 est une vue en perspective, depuis l'avant, du châssis transversal visible sur la figure 6 supportant l'ensemble de ses équipements,
- la figure 13 est une vue en perspective, depuis l'arrière, du châssis transversal visible sur la figure 6 positionné dans une soute avionique, équipé d'au moins une cloison d'étanchéité et de surpression qui illustre un mode de réalisation de l'invention,
- la figure 14A est une représentation schématique de côté d'une cloison d'étanchéité et de surpression, à l'état repos,
- la figure 14B est une représentation schématique de côté de la cloison d'étanchéité et de surpression visible sur la figure 14A, à l'état détaché après une surpression,
- la figure 14C est une représentation schématique de côté de la cloison d'étanchéité et de surpression visible sur la figure 14B, à l'état démonté,
- la figure 15 est une vue en perspective d'un module d'assemblage comprenant un châssis transversal qui illustre un mode de réalisation de l'invention,
- la figure 16 est une vue latérale du module d'assemblage visible sur la figure 15 et d'une pointe avant d'un aéronef avant une étape de mise en place dudit module d'assemblage dans la pointe avant, et
- la figure 17 est une vue latérale du module d'assemblage et de la pointe avant visibles sur la figure 16, après l'étape de mise en place dudit module d'assemblage dans la pointe avant.

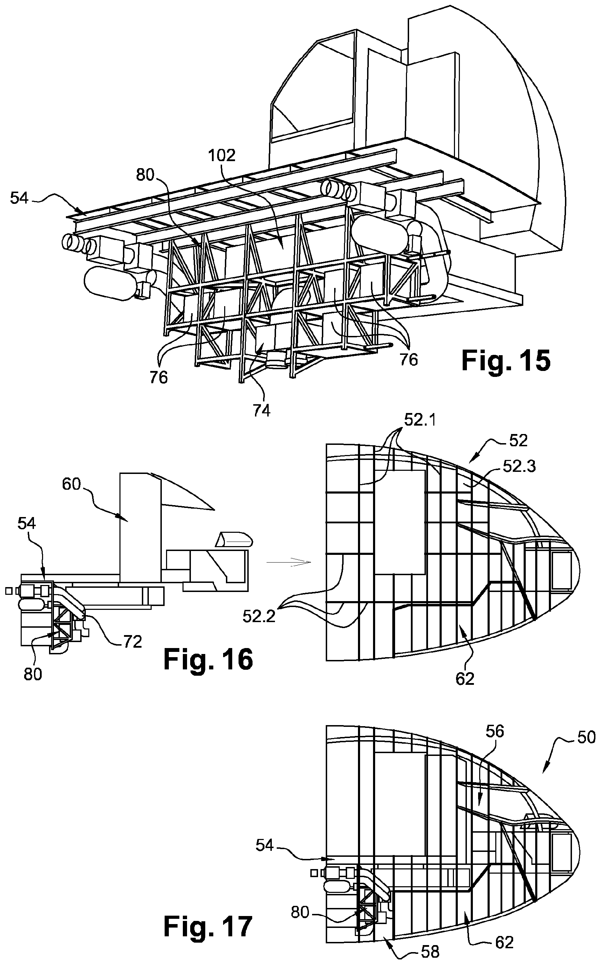

Selon un mode de réalisation illustré par les figures 16 et 17, une pointe avant 50 d'un aéronef comprend une structure primaire 52 qui comporte des raidisseurs transversaux 52.1 appelés cadres, des raidisseurs longitudinaux 52.2 appelés lisses et une peau 52.3 qui forme l'enveloppe extérieure de l'aéronef. La pointe avant 50 comprend un plancher 54 relié à la structure primaire 52 qui divise la pointe avant en deux zones, une zone supérieure qui correspond à une cabine de pilotage 56 et une zone inférieure qui correspond à une soute avionique 58. La pointe avant 50 comprend également une structure secondaire supérieure 60 (visible sur la figure 16) qui comporte des panneaux qui cloisonnent et recouvrent l'intérieur de la structure primaire 52 et différents équipements, accessoires, meubles, qui sont positionnés au-dessus du plancher 54 une fois assemblés.

Selon une configuration visible sur les figures 4, 5 et 17, la soute avionique 58 est délimitée par le plancher 54 en partie supérieure, la structure primaire 52 en partie inférieure et sur les côtés, une case de train avant 62 en partie inférieure et une frontière arrière 64 (visible sur la figure 4) qui sépare la soute avionique 58 et une deuxième soute, notamment une soute à bagages 66.

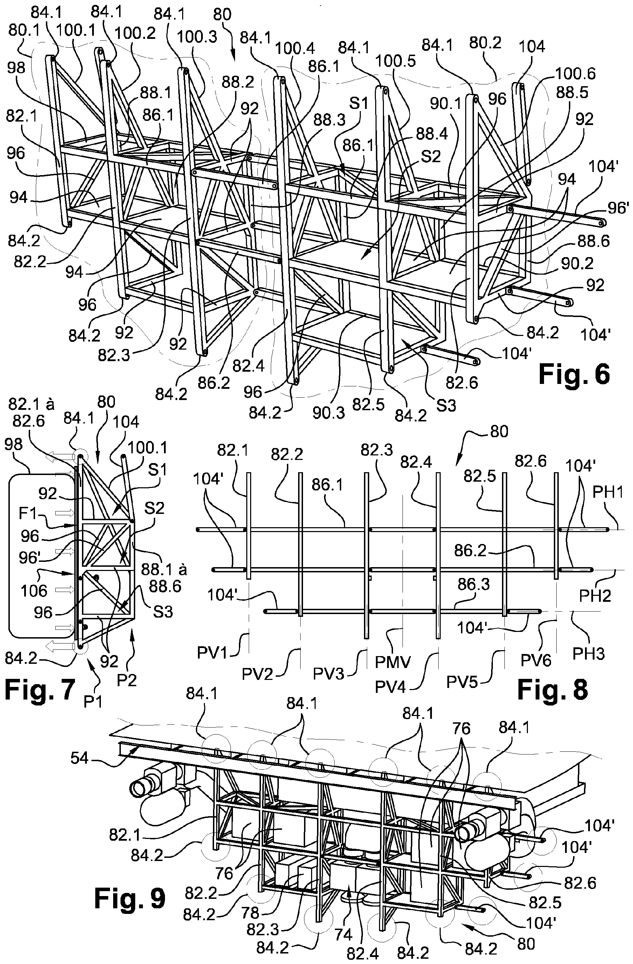

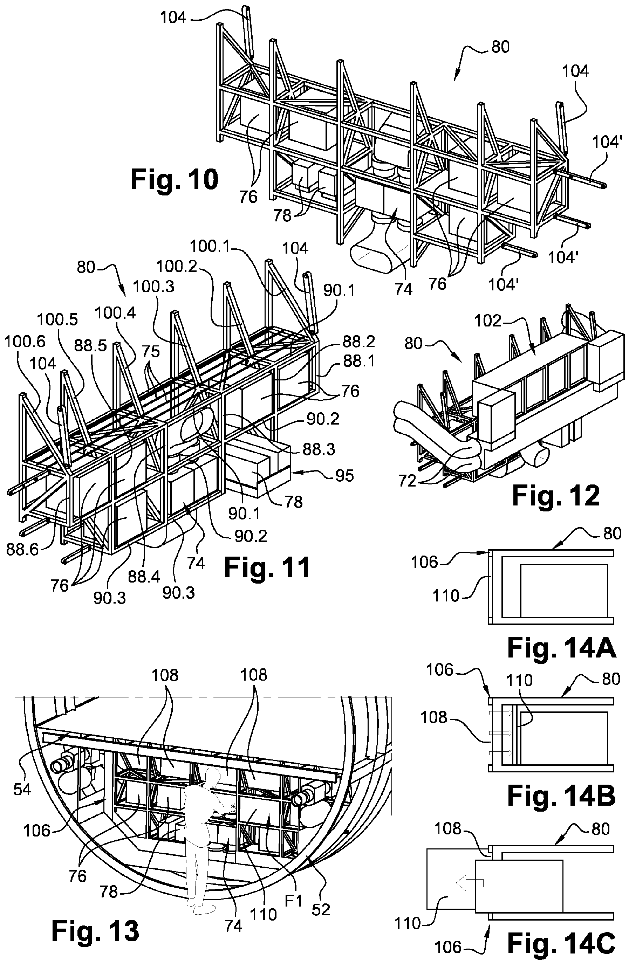

Selon une configuration, la soute avionique 58 comprend :
- au-dessus de la case de train avant 62, deux rangées longitudinales de meubles avioniques 68, 68', parallèles à l'axe longitudinal 18, disposées de part et d'autre d'une zone de dégagement 70 et de manière symétrique par rapport à un plan médian vertical PMV qui passe par l'axe longitudinal A18,
- un dispositif de conditionnement de l'air qui présente des canalisations transversales 72 (visibles sur les figures 4 et 12) positionnées dans des plans transversaux, à l'arrière de la case de train avant 62, et un système de traitement de l'air 74 (visible sur les figures 9, 10, 11, 13 et 15) positionné à l'arrière de la case de train avant 62,
- des routes électriques 75 (visibles sur les figures 4 et 11),
- d'autres équipements, comme des batteries 76 (visibles sur les figures 4, 9, 10, 11 et 15) et des centrales inertielles 78 visibles sur les figures 10, 11 et 13).

Tous ces éléments ne sont pas plus décrits car ils sont connus de l'homme du métier.

Selon une caractéristique de l'invention, la soute avionique 58 comprend un châssis transversal 80, positionné à l'arrière de la case de train avant 62.

Selon un mode de réalisation visible sur les figures 6 à 8 et 11, le châssis transversal 80 comprend :
- des bielles 82.1 à 82.6 verticales, positionnées dans un premier plan transversal P1, qui comprennent chacune à une extrémité supérieure une première connexion 84.1, configurée pour être reliée à un point d'ancrage prévu au niveau du plancher 54 et, à une extrémité inférieure, une deuxième connexion 84.2 configurée pour être reliée à un point d'ancrage prévu au niveau de la structure primaire 52,
- des premières traverses 86.1 à 86.3 horizontales, reliant les bielles 82.1 à 82.6 deux à deux, positionnées dans le premier plan transversal P1,
- des montants 88.1 à 88.6 verticaux, positionnés dans un deuxième plan transversal P2 parallèle au plan P1 et espacé de ce dernier,
- des deuxièmes traverses 90.1 à 90.3 horizontales, reliant les montants 88.1 à 88.6 deux à deux, positionnées dans le deuxième plan transversal P2,
- des longerons 92, horizontaux et orientés perpendiculairement au premier plan transversal P1, reliant les bielles 82.1 à 82.6 et les montants 88.1 à 88.6 deux à deux.

Les bielles 82.1 à 82.6 sont disposées de manière symétrique par rapport au plan médian vertical PMV. Selon une configuration, le châssis transversal 80 comprend six bielles 82.1 à 82.6 réparties sur toute la largeur de la soute avionique 58, la largeur correspondant à la dimension de la soute dans le premier plan transversal P1. Les bielles sont numérotées 82.1 à 82.6 de la gauche vers la droite, en regardant de l'arrière vers l'avant de l'aéronef.

Les bielles 82.1 à 82.6 sont reliées par une première série de premières traverses 86.1 hautes positionnées dans un même premier plan longitudinal horizontal PH1, par une deuxième série de premières traverses 86.2 intermédiaires positionnées dans un même deuxième plan longitudinal horizontal PH2 et par une troisième série de premières traverses 86.3 basses positionnées dans un même troisième plan longitudinal horizontal PH3.

Selon une configuration, les première et deuxième bielles 82.1 et 82.2 sont reliées par une première traverse 86.1 haute et une première traverse 86.2 intermédiaire ; les deuxième et troisième bielles 82.2 et 82.3 sont reliées par une première traverse 86.1 haute, une première traverse 86.2 intermédiaire et une première traverse 86.3 basse ; les troisième et quatrième bielles 82.3 et 82.4 sont reliées par une première traverse 86.1 haute et une première traverse 86.2 intermédiaire ; les quatrième et cinquième bielles 82.4 et 82.5 sont reliées par une première traverse 86.1 haute, une première traverse 86.2 intermédiaire et une première traverse 86.3 basse et les cinquième et sixième bielles 82.5 et 82.6 sont reliées par une première traverse 86.1 haute et une première traverse 86.2 intermédiaire.

Le châssis transversal 80 comprend autant de montants 88.1 à 88.6 que de bielles 82.1 à 82.6. Ainsi, le châssis transversal 80 comprend six montants 88.1 à 88.6 répartis sur toute la largeur de la soute avionique 58, les montants 88.1 à 88.6 étant disposés respectivement dans les mêmes plans longitudinaux verticaux PV1 à PV6 que les bielles 82.1 à 82.6.

Les montants 88.1 à 88.2 sont reliés par une première série de deuxièmes traverses 90.1 hautes positionnées dans le même premier plan longitudinal horizontal PH1 que les premières traverses 86.1 hautes, par une deuxième série de deuxièmes traverses 90.2 intermédiaires positionnées dans le même deuxième plan longitudinal horizontal PH2 que les premières traverses 86.2 intermédiaires et par une troisième série de deuxièmes traverses 90.3 basses positionnées dans le même troisième plan longitudinal horizontal PH3 que les premières traverses 86.3 basses.

Selon une configuration, les premier et deuxième montants 88.1 et 88.2 sont reliés par une deuxième traverse 90.1 haute et une deuxième traverse 90.2 intermédiaire ; les deuxième et troisième montants 88.2 et 88.3 sont reliés par une deuxième traverse 90.1 haute et une deuxième traverse 90.2 intermédiaire ; les troisième et quatrième montants 88.3 et 88.4 sont reliés par une deuxième traverse 90.1 haute, une deuxième traverse 90.2 intermédiaire et une deuxième traverse 90.3 basse ; les quatrième et cinquième montants 88.4 et 88.5 sont reliés par une deuxième traverse 90.1 haute, une deuxième traverse 90.2 intermédiaire et une deuxième traverse 90.3 basse et les cinquième et sixième montants 88.5 et 88.6 sont reliés par une deuxième traverse 90.1 haute et une deuxième traverse 90.2 intermédiaire.

Selon un mode de réalisation visible sur la figure 11, les premier et sixième montants 88.1 et 88.6 relient les deuxièmes traverses 90.1 hautes et les deuxièmes traverses 90.2 intermédiaires et ne s'étendent pas au-delà de ces dernières. Les autres montants 88.2 à 88.5 relient les deuxièmes traverses 90.1 hautes et les deuxièmes traverses 90.3 basses et ne s'étendent pas au-delà de ces dernières.

Selon une configuration, chaque point de jonction des bielles 82.1 à 82.6 et des premières traverses 86.1 à 86.3 est relié par un longeron 92 au point de jonction correspondant (même plan longitudinal vertical PV1 à PV6 et même plan longitudinal horizontal PH1 à PH3) des montants 88.1 à 88.6 et des deuxièmes traverses 90.1 à 90.3.

Bien entendu, l'invention n'est pas limitée à ce nombre de bielles et de montants, ni à cette configuration pour les première et deuxième traverses.

Quel que soit le mode de réalisation, les bielles 82.1 à 82.6, les montants 88.1 à 88.6, les premières et deuxièmes traverses 86.1 à 86.3 et 90.1 à 90.3 et les longerons 92 sont agencés de manière à ce que le châssis transversal 80 forme une structure à mailles carrées et/ou rectangulaires ; deux longerons 92, une première traverse 86.1 à 86.3 et une deuxième traverse 90.1 à 90.3 formant une maille horizontale ; deux longerons, une bielle 82.1 à 82.6 et un montant 88.1, 88.6 formant une maille verticale longitudinale ; deux premières traverses 86.1 à 86.3 et deux bielles 82.1 à 82.6 ou deux deuxièmes traverses 90.1 à 90.3 et deux montants 88.1 à 88.6 formant une maille verticale transversale.

Selon un mode de réalisation, le châssis transversal 80 est métallique et mécanosoudé. Bien entendu, l'invention n'est pas limitée à cette matière et à ce mode de réalisation.

Selon une configuration visible sur les figures 6 et 11, les premières et deuxièmes traverses disposées entre deux plans longitudinaux verticaux consécutifs PV3 et PV4, reliant les troisième et quatrième bielles 82.3 et 82.4 ainsi que les troisième et quatrième montants 88.3 et 88.4 sont démontables. Ainsi, le châssis transversal 80 comprend deux sous-ensembles 80.1, 80.2 mécanosoudés qui sont fabriqués indépendamment l'un de l'autre et qui peuvent être reliés au plancher 54 indépendamment l'un de l'autre.

Selon une configuration, le premier plan transversal P1, au niveau duquel sont positionnées les bielles 82.1 à 82.6, est décalé vers l'arrière par rapport au deuxième plan transversal P2 au niveau duquel sont positionnés les montants 88.1 à 88.6. Le premier plan transversal P1 forme une face frontale F1 du châssis transversal 80 accessible depuis la soute à bagages 66.

Les première et deuxième traverses 86.1 à 86.3 ; 90.1 à 90.3 et les longerons 92 disposés dans le même plan longitudinal horizontal PH1 ou PH3 forment un support horizontal continu ou discontinu. Ainsi, le châssis transversal 80 comprend un support horizontal haut S1 disposé dans le plan longitudinal horizontal PH1, un support horizontal intermédiaire S2 disposé dans le plan longitudinal horizontal PH2 et un support horizontal bas S3 disposé dans le plan longitudinal horizontal PH3.

Selon un mode de réalisation, le châssis transversal 80 comprend au moins une tablette 94, positionnée au niveau d'au moins une des mailles horizontales et supportée par deux longerons 92, une première traverse 86.1 à 86.3 et une deuxième traverse 90.1 à 90.3. Chaque tablette 94 a un pourtour sensiblement identique à la maille horizontale qui la reçoit. Cette tablette 94 forme une étagère.

Ces tablettes 94 sont positionnées en fonction des équipements installés dans le châssis transversal 80. A titre d'exemple, elles sont utilisées pour soutenir les batteries 76.

Selon un mode de réalisation, le châssis transversal 80 comprend au moins une liaison glissière 95 (visible sur la figure 11), comme deux rails, reliant un équipement et le châssis transversal 80, configurée pour permettre au dit équipement de se translater, par rapport au châssis transversal, selon une direction perpendiculaire au premier plan transversal P1 afin de favoriser son extraction.

Le châssis transversal 80 comprend au moins un renfort oblique 96. Au moins certaines mailles du châssis transversal 80 comprennent des renforts obliques 96 de manière à obtenir une structure en treillis. Les renforts obliques 96 sont positionnés de manière à renforcer la reprise des efforts selon la direction longitudinale, d'avant en arrière. Ainsi, les renforts obliques 96 sont prévus au niveau d'au moins certaines mailles verticales longitudinales et/ou des mailles horizontales. Ainsi, comme illustré sur la figure 7, le châssis transversal 80 assure une reprise efficace des efforts en cas de désarrimage d'un conteneur 98.

Au moins certains de ces renforts obliques 96', disposés au niveau des mailles verticales longitudinales, inclinés vers le bas et vers le premier plan transversal assurent la transmission des charges exercées au niveau du deuxième plan transversal P2 vers les points d'ancrage prévus au niveau de la structure primaire 52.

Le châssis transversal 80 comprend des suspentes inclinées 100.1 à 100.6, chacune d'elles reliant l'extrémité supérieure d'une bielle 82.1 à 82.6 et un montant 88.1 à 88.6. Ces suspentes inclinées 100.1 à 100.6 assurent la transmission des charges exercées au niveau du deuxième plan transversal P2 vers les points d'ancrage prévus au niveau du plancher 54.

Selon une configuration, le châssis transversal 80 comprend des suspentes inclinées d'extrémité 100.1, 100.6 reliant les extrémités supérieures des première et dernière bielles 82.1, 82.6 et des premier et dernier montants 88.1, 88.6 ainsi que des suspentes inclinées intermédiaires 100.2 à 100.5 reliant l'extrémité supérieure des bielles 82.2 à 82.5 et les montants 88.2 à 88.5 au niveau des deuxièmes traverses 90.2 intermédiaires. Ainsi, une partie du support horizontal haut S1 orientée vers le deuxième plan transversal P2 est dégagée et n'est pas entravée par les suspentes inclinées intermédiaires 82.2 à 82.5 ce qui permet d'y positionner un meuble avionique transversal 102 situé à l'arrière des deux rangées longitudinales de meubles avioniques 68, 68', comme illustré sur les figures 5, 9 et 15.

Les suspentes inclinées 100.1 à 100.6 et les renforts obliques 96, 96' permettent de transférer les charges du deuxième plan transversal P2 vers le premier plan transversal P1 si bien qu'il n'est pas nécessaire que les montants 88.1 à 88.6 soient reliés au plancher 54 ou à la structure primaire 52. Cette conception permet de réduire le nombre de points de fixation entre le châssis transversal 80 et la structure primaire 52/le plancher 54.

Selon une autre caractéristique, le châssis transversal 80 comprend des biellettes 104 pour le relier à la structure primaire 52 ou au plancher 54. Selon une configuration, deux biellettes 104 relient les extrémités supérieures des premier et dernier montants 88.1 et 88.6 et le plancher 54. Des biellettes 104' relient les longerons 92 positionnés à chaque extrémité des supports horizontaux S1 à S3, les biellettes 104' étant positionnées dans un plan transversal (parallèle aux premier et deuxième plans transversaux P1 et P2) positionné entre les premier et deuxième plans transversaux P1 et P2 et assurant la reprise des efforts selon une direction transversale horizontale.

Selon un mode de réalisation visible sur la figure 13, la face frontale F1 du châssis transversal 80 comprend une cloison d'étanchéité et de surpression 106, assurant l'étanchéité entre la soute avionique 58 et la soute à bagages 66, prenant appui contre les bielles 82.1 à 82.6. Pour permettre l'accès au châssis transversal 80, la cloison d'étanchéité et de surpression 106 comprend au moins une ouverture 108. Selon une configuration, la cloison d'étanchéité et de surpression 106 comprend une ouverture 108 pour chaque maille verticale transversale située au niveau du premier plan transversal P1 et pour chaque zone située entre les bielles 82.1 à 82.6, au-dessus des premières traverses 86.1 hautes.

Pour chaque ouverture 108, la cloison d'étanchéité et de surpression 106 comprend un panneau de surpression 110. Chaque panneau de surpression 110 est configuré pour occuper un état repos, visible sur la figure 14A, dans lequel il obture l'ouverture 108, un état détaché après une surpression, visible sur la figure 14B, dans lequel il dégage au moins partiellement l'ouverture 108 et un état démonté, visible sur la figure 14C, dans lequel il dégage totalement l'ouverture 108 pour permettre l'accès au châssis transversal 80 depuis la soute à bagages 66.

A cet effet, la cloison d'étanchéité et de surpression 106 comprend, pour chaque panneau de surpression 110, une liaison, reliant ledit panneau de surpression 110 au reste de la cloison d'étanchéité et de surpression 106, configurée pour assurer une étanchéité à l'état repos entre ledit panneau de surpression 110 et le reste de la cloison d'étanchéité et de surpression 106, pour se rompre lorsqu'une différence de pression de part et d'autre de la cloison d'étanchéité et de surpression 106 dépasse un seuil donné pour passer de l'état repos à l'état détaché, pour assurer un démontage et un remontage dudit panneau de surpression 110.

Selon un mode de réalisation, au moins un lien (de préférence quatre liens à chaque coin du panneau de surpression 110) est prévu pour relier le panneau de surpression 110 et le reste de la cloison d'étanchéité et de surpression 106 afin de limiter la course du panneau de surpression 110 lors du passage de l'état repos à l'état détaché en cas de surpression.

Selon un agencement visible sur les figures 4, 12 et 15, les routes électriques 75 sont positionnées sur la partie arrière du support horizontal haut S1. Un meuble avionique transversal 102 est positionné, au moins partiellement, sur la partie avant du support horizontal haut S1. Des canalisations transversales 72 sont fixées sur les montants 88.1 à 88.2 et/ou les deuxièmes traverses 90.1 à 90.3, sous le meuble avionique transversal 102. Un système de traitement de l'air 74 est positionné entre les troisième et quatrième bielles 82.3, 82.4. Enfin, des batteries 76 et des centrales inertielles 78 sont positionnées sur le support horizontal intermédiaire S2 et le support horizontal bas S3 de part et d'autre des troisième et quatrième bielles 82.3, 82.4. Bien entendu, l'invention n'est pas limitée à cet agencement. D'autres agencements sont envisageables.

Selon un procédé d'assemblage, un module d'assemblage 112, comprenant le plancher 54, la structure secondaire supérieure 60, le châssis transversal 80 et ses équipements, est assemblé, le châssis transversal 80 étant fixé au plancher 54 grâce aux premières connexions 84.1 et aux biellettes 104. Cette opération peut être réalisée en même temps que la structure primaire 52 de la pointe avant.

En suivant, le module d'assemblage 112 est inséré dans la structure primaire 52 et relié à ladite structure primaire 52. Le châssis transversal 80 est fixé à la structure primaire 52 grâce aux deuxièmes connexions 84.2 et aux biellettes 104'.

La cloison d'étanchéité et de surpression 106 est mise en place ainsi que les panneaux de surpression 110 avant ou après l'insertion du module d'assemblage 112.

Comme illustré sur les figures 4 et 5, le châssis transversal 80 permet d'optimiser l'encombrement de la soute avionique 58, une partie du couloir prévue entre les meubles avioniques longitudinaux 68, 68' de l'art antérieur étant occupée par le châssis transversal 80. Selon cette configuration, tous les équipements de la soute avionique 58 sont accessibles depuis la zone de dégagement 70 ou depuis la soute à bagages 66. L'optimisation de l'encombrement de la soute avionique 58 permet d'augmenter le volume de la soute à bagages 66.

La présence de panneaux de surpression 110 démontables au niveau de la cloison d'étanchéité et de surpression 106 favorise l'accessibilité aux équipements installés sur le châssis transversal 80.

La structure à mailles, éventuellement renforcée, du châssis transversal permet de réduire la zone de rétention destinée à la reprise des efforts en cas de désarrimage d'un conteneur dans la soute à bagages 66, ce qui permet in fine d'augmenter le volume de la soute à bagages 66.

Selon un autre aspect, le châssis transversal 80 comprend un nombre de connexions réduit avec le plancher 54 et la structure primaire 52, ce qui permet de réduire le temps d'assemblage. Par ailleurs, ces connexions étant positionnées au niveau du premier plan transversal P1, elles sont aisément accessibles depuis la soute à bagages 66.

Enfin, le châssis transversal 80 permet de pouvoir solidariser à un module d'assemblage les équipements présents dans la soute avionique 58 et de les introduire, en une seule étape, dans la structure primaire 52 de l'aéronef.

## Revendications

1. Aéronef comprenant une soute avionique (58) séparée d'une deuxième soute (66) par une frontière arrière (64) et un châssis transversal pour la soute avionique (58), ladite soute avionique étant délimitée par une structure primaire (52) et un plancher (54), dans lequel châssis transversal comprend :
- des bielles (82.1 à 82.6) verticales, positionnées dans un premier plan transversal (P1), qui comprennent chacune, à une extrémité supérieure, une première connexion (84.1) reliée à un point d'ancrage prévu au niveau du plancher (54) et, à une extrémité inférieure, une deuxième connexion (84.2) reliée à un point d'ancrage prévu au niveau de la structure primaire (52),
- des premières traverses (86.1 à 86.3) horizontales, reliant les bielles (82.1 à 82.6) deux à deux, positionnées dans le premier plan transversal (P1),
- des montants (88.1 à 88.6) verticaux, positionnés dans un deuxième plan transversal (P2) espacé du premier plan transversal (P1),
- des deuxièmes traverses (90.1 à 90.3) horizontales, reliant les montants (88.1 à 88.6) deux à deux, positionnées dans le deuxième plan transversal (P2),
- des longerons (92), horizontaux et orientés perpendiculairement au premier plan transversal (P1), reliant les bielles (82.1 à 82.6) et les montants (88.1 à 88.6) deux à deux,
- les bielles (82.1 à 82.6), les montants (88.1 à 88.6), les premières et deuxièmes traverses (86.1 à 86.3, 90.1 à 90.3) et les longerons (92) étant agencés de manière à ce que le châssis transversal (80) forme une structure à mailles carrées et/ou rectangulaires.

2. Aéronef selon la revendication 1, **caractérisé en ce qu'**au moins certaines mailles du châssis transversal (80) comprennent des renforts obliques (96, 96') de manière à obtenir une structure en treillis.

3. Aéronef selon la revendication 2, **caractérisé en ce qu'**au moins certains des renforts obliques (96') sont disposés au niveau de mailles verticales longitudinales et sont inclinés vers le bas et vers le premier plan transversal (P1).

4. Aéronef selon l'une des revendications précédentes, **caractérisé en ce que** le châssis transversal (80) comprend des suspentes inclinées (100.1 à 100.6), chacune d'elles reliant une bielle (82.1 à 82.6) et un montant (88.1 à 88.6).

5. Aéronef selon la revendication précédente, **caractérisé en ce que** les longerons (92) et les premières et deuxièmes traverses (86.1, 90.1) disposés dans un même plan horizontal, le plus haut, forment un support horizontal haut (S1) et **en ce que** certaines des suspentes inclinées (100.2 à 100.5) sont reliées aux montants (88.1 à 88.6) de manière à dégager une partie du support horizontal haut (S1) orientée vers le deuxième plan transversal (P2).

6. Aéronef selon l'une des revendications précédentes, **caractérisé en ce que** le châssis transversal comprend au moins une tablette (94) positionnée au niveau d'au moins une des mailles horizontales et formant une étagère.

7. Aéronef selon l'une des revendications précédentes, **caractérisé en ce que** le châssis transversal (80) comprend au moins une liaison glissière (95) reliant un équipement et le châssis transversal (80), configurée pour permettre au dit équipement de se translater selon une direction perpendiculaire au premier plan transversal (P1) par rapport au châssis transversal (80).

8. Aéronef selon l'une des revendications précédentes, **caractérisé en ce que** les premières et deuxièmes traverses disposées entre deux plans longitudinaux verticaux consécutifs (PV3, PV4) sont démontables de manière à scinder le châssis transversal en deux sous-ensembles (80.1, 80.2).

9. Aéronef selon l'une des revendications 1 à 8, **caractérisé en ce que** le premier plan transversal (P1) du châssis transversal (80) est positionné perpendiculairement à une direction longitudinale de l'aéronef, au niveau de la frontière arrière (64).

10. Aéronef selon la revendication précédente, **caractérisé en ce que** le châssis transversal (80) comprend une cloison d'étanchéité et de surpression (106) prenant appui contre les bielles (82.1 à 82.6) et assurant une étanchéité entre la soute avionique (58) et la deuxième soute (66), ladite cloison d'étanchéité et de surpression (106) comprenant au moins une ouverture (108) et pour chaque ouverture (108) un panneau de surpression (110) configuré pour occuper un état repos dans lequel le panneau de surpression (110) obture l'ouverture (108) et un état détaché après une surpression dans lequel le panneau de surpression (110) dégage au moins partiellement l'ouverture (108).

11. Aéronef selon la revendication précédente, **caractérisé en ce que** la cloison d'étanchéité et de surpression (106) comprend une ouverture (108) pour chaque maille verticale transversale située au niveau du premier plan transversal (P1) et pour chaque zone située entre les bielles (82.1 à 82.6), au-dessus des premières traverses (86.1) les plus hautes.

12. Aéronef selon l'une des revendications précédentes, **caractérisé en ce que** la soute avionique (58) comprend deux rangées longitudinales de meubles avioniques (68, 68'), parallèles à la direction longitudinale et disposés de part et d'autre d'une zone de dégagement (70), un meuble avionique transversal (102) supporté par le châssis transversal (80) situé à l'arrière des deux rangées longitudinales de meubles avioniques (68, 68').

## Patentansprüche

1. Luftfahrzeug, welches einen Avionikraum (58), der von einem zweiten Frachtraum (66) durch eine hintere Grenze (64) getrennt ist, und einen Querrahmen für den Avionikraum (58) umfasst, wobei der Avionikraum von einer von einer primären Struktur (52) und einem Fußboden (54) begrenzt wird, wobei der Querrahmen umfasst:
- vertikale Stangen (82.1 bis 82.6), die in einer ersten Querebene (P1) positioniert sind und die jeweils an einem oberen Ende eine erste Verbindung (84.1), die mit einem am Fußboden (54) vorgesehenen Verankerungspunkt verbunden ist, und an einem unteren Ende eine zweite Verbindung (84.2), die mit einem an der primären Struktur (52) vorgesehenen Verankerungspunkt verbunden ist, umfassen,
- erste horizontale Querstreben (86.1 bis 86.3), welche die Stangen (82.1 bis 82.6) paarweise verbinden und in der ersten Querebene (P1) positioniert sind,
- vertikale Stützen (88.1 bis 88.6), die in einer zweiten Querebene (P2) positioniert sind, die von der ersten Querebene (P1) beabstandet ist,
- zweite horizontale Querstreben (90.1 bis 90.3), welche die Stützen (88.1 bis 88.6) paarweise verbinden und in der zweiten Querebene (P2) positioniert sind,
- horizontale und senkrecht zur ersten Querebene (P1) ausgerichtete Längsträger (92), welche die Stangen (82.1 bis 82.6) und die Stützen (88.1 bis 88.6) paarweise verbinden,
- wobei die Stangen (82.1 bis 82.6), die Stützen (88.1 bis 88.6), die ersten und zweiten Querstreben (86.1 bis 86.3, 90.1 bis 90.3) und die Längsträger (92) derart angeordnet ist, dass der Querrahmen (80) eine Struktur mit quadratischen und/oder rechteckigen Maschen bildet.

2. Luftfahrzeug nach Anspruch 1, **dadurch gekennzeichnet, dass** wenigstens einige Maschen des Querrahmens (80) schräge Aussteifungen (96, 96') umfassen, so dass ein Fachwerk erhalten wird.

3. Luftfahrzeug nach Anspruch 2, **dadurch gekennzeichnet, dass** wenigstens einige der schrägen Aussteifungen (96') im Bereich von in Längsrichtung angeordneten vertikalen Maschen angeordnet sind und nach unten und zur ersten Querebene (P1) hin geneigt sind.

4. Luftfahrzeug nach einem der vorhergehenden Ansprüche, **dadurch gekennzeichnet, dass** der Querrahmen (80) geneigte Aufhänger (100.1 bis 100.6) umfasst, die jeweils eine Stange (82.1 bis 82.6) und eine Stütze (88.1 bis 88.6) verbinden.

5. Luftfahrzeug nach dem vorhergehenden Anspruch, **dadurch gekennzeichnet, dass** die Längsträger (92) und die ersten und zweiten Querstreben (86.1, 90.1), die in derselben horizontalen Ebene, der höchsten, angeordnet sind, eine hohe horizontale Abstützung (S1) bilden, und dadurch, dass einige der geneigten Aufhänger (100.2 bis 100.5) derart mit den Stützen (88.1 bis 88.6) verbunden sind, dass ein Teil der oberen horizontalen Abstützung (S1), welcher der zweiten Querebene (P2) zugewandt ist, freigelegt wird.

6. Luftfahrzeug nach einem der vorhergehenden Ansprüche, **dadurch gekennzeichnet, dass** der Querrahmen wenigstens eine Platte (94) umfasst, die im Bereich wenigstens einer der horizontalen Maschen positioniert ist und ein Regal bildet.

7. Luftfahrzeug nach einem der vorhergehenden Ansprüche, **dadurch gekennzeichnet, dass** der Querrahmen (80) wenigstens eine Gleitverbindung (95), die einen Ausrüstungsgegenstand und den Querrahmen (80) verbindet, umfasst, die dafür ausgelegt ist zu ermöglichen, dass sich der Ausrüstungsgegenstand in einer Richtung senkrecht zur ersten Querebene (P1) in Bezug auf den Querrahmen (80) verschiebt.

8. Luftfahrzeug nach einem der vorhergehenden Ansprüche, **dadurch gekennzeichnet, dass** die ersten und zweiten Querstreben, die zwischen zwei aufeinander folgenden vertikalen Längsebenen (PV3, PV4) angeordnet sind, demontierbar sind, derart, dass der Querrahmen in zwei Unterbaugruppen (80.1, 80.2) geteilt wird.

9. Luftfahrzeug nach einem der Ansprüche 1 bis 8, **dadurch gekennzeichnet, dass** die erste Querebene (P1) des Querrahmens (80) an der hinteren Grenze (64) senkrecht zu einer Längsrichtung des Luftfahrzeugs positioniert ist.

10. Luftfahrzeug nach dem vorhergehenden Anspruch, **dadurch gekennzeichnet, dass** der Querrahmen (80) eine Dichtungs- und Überdrucktrennwand (106) umfasst, die sich an den Stangen (82.1 bis 82.6) abstützt und eine Dichtigkeit zwischen dem Avionikraum (58) und dem zweiten Frachtraum (66) sicherstellt, wobei die Dichtungs- und Überdrucktrennwand (106) wenigstens eine Öffnung (108) und für jede Öffnung (108) eine Überdruckplatte (110) umfasst, die dafür ausgelegt ist, einen Ruhezustand, in welchem die Überdruckplatte (110) die Öffnung (108) verschließt, und einen nach einem Überdruck losgelösten Zustand, in welchem die Überdruckplatte (110) die Öffnung (108) wenigstens teilweise freigibt, einzunehmen.

11. Luftfahrzeug nach dem vorhergehenden Anspruch, **dadurch gekennzeichnet, dass** die Dichtungs- und Überdrucktrennwand (106) eine Öffnung (108) für jede in Querrichtung angeordnete vertikale Masche, die sich im Bereich der ersten Querwand (P1) befindet, und für jeden Bereich, der sich zwischen den Stangen (82.1 bis 82.6) oberhalb der ersten Querstreben (86.1), den höchsten, befindet, umfasst.

12. Luftfahrzeug nach einem der vorhergehenden Ansprüche, **dadurch gekennzeichnet, dass** der Avionikraum (58) zwei Längsreihen von Avionik-Möbelstücken (68, 68') umfasst, die parallel zur Längsrichtung sind und beiderseits eines Freiraumes (70) angeordnet sind, und ein von dem Querrahmen (80) getragenes, quer angeordnetes Avionik-Möbelstück (102), das sich hinter den zwei Längsreihen von Avionik-Möbelstücken (68, 68') befindet.

## Claims

1. Aircraft comprising an avionics bay (58) separated from a second bay (66) by a rear boundary (64) and a transverse chassis for the avionics bay (58), said avionics bay being delimited by a primary structure (52) and a floor (54), in which the transverse chassis comprises:
- vertical rods (82.1 to 82.6), positioned in a first transverse plane (P1) and each comprising, at an upper end, a first connection (84.1) connected to an anchoring point provided at the floor (54) and, at a lower end, a second connection (84.2) connected to an anchoring point provided at the primary structure (52),
- first horizontal crossmembers (86.1 to 86.3) connecting the rods (82.1 to 82.6) in pairs, positioned in the first transverse plane (P1),
- vertical uprights (88.1 to 88.6), positioned in a second transverse plane (P2) that is spaced apart from the first transverse plane (P1),
- second horizontal crossmembers (90.1 to 90.3), connecting the uprights (88.1 to 88.6) in pairs, positioned in the second transverse plane (P2),
- horizontal longerons (92) oriented perpendicular to the first transverse plane (P1) and connecting the rods (82.1 to 82.6) and the uprights (88.1 to 88.6) in pairs,
- the rods (82.1 to 82.6), the uprights (88.1 to 88.6), the first and second crossmembers (86.1 to 86.3, 90.1 to 90.3) and the longerons (92) being arranged such that the transverse chassis (80) forms a structure having square and/or rectangular voids.

2. Aircraft according to Claim 1, **characterized in that** at least some voids of the transverse chassis (80) comprise oblique reinforcements (96, 96') so as to obtain a lattice structure.

3. Aircraft according to Claim 2, **characterized in that** at least some of the oblique reinforcements (96') are arranged at longitudinal vertical voids and are inclined downwards and towards the first transverse plane (P1).

4. Aircraft according to one of the preceding claims, **characterized in that** the transverse chassis (80) comprises inclined suspenders (100.1 to 100.6), each one of these connecting a rod (82.1 to 82.6) and an upright (88.1 to 88.6).

5. Aircraft according to the preceding claim, **characterized in that** the longerons (92) and the first and second crossmembers (86.1, 90.1) arranged in one and the same uppermost horizontal plane form an upper horizontal support (S1), and **in that** some of the inclined suspenders (100.2 to 100.5) are connected to the uprights (88.1 to 88.6) so as to leave free a part of the upper horizontal support (S1) that is oriented towards the second transverse plane (P2).

6. Aircraft according to one of the preceding claims, **characterized in that** the transverse chassis comprises at least one plate (94) positioned at at least one of the horizontal voids and forming a shelf.

7. Aircraft according to one of the preceding claims, **characterized in that** the transverse chassis (80) comprises at least one sliding connection (95) connecting an item of equipment and the transverse chassis (80), this being configured to allow said item of equipment to move in translation in a direction perpendicular to the first transverse plane (P1) relative to the transverse chassis (80).

8. Aircraft according to one of the preceding claims, **characterized in that** the first and second crossmembers arranged between two consecutive vertical longitudinal planes (PV3, PV4) can be dismantled so as to split the transverse chassis into two subassemblies (80.1, 80.2).

9. Aircraft according to one of Claims 1 to 8, **characterized in that** the first transverse plane (P1) of the transverse chassis (80) is positioned perpendicular to a longitudinal direction of the aircraft, at the rear boundary (64).

10. Aircraft according to the preceding claim, **characterized in that** the transverse chassis (80) comprises a sealing overpressure partition (106) that presses against the rods (82.1 to 82.6) and provides a seal between the avionics bay (58) and the second bay (66), said sealing overpressure partition (106) comprising at least one opening (108) and, for each opening (108), an overpressure panel (110) configured to be in a resting state in which the overpressure panel (110) blocks the opening (108) and a detached state after an overpressure event in which the overpressure panel (110) leaves the opening (108) at least partially free.

11. Aircraft according to the preceding claim, **characterized in that** the sealing overpressure partition (106) comprises an opening (108) for each transverse vertical void located at the level of the first transverse plane (P1) and for each region located between the rods (82.1 to 82.6), above the uppermost first crossmembers (86.1).

12. Aircraft according to one of the preceding claims, **characterized in that** the avionics bay (58) comprises two longitudinal rows of avionics racks (68, 68'), these being parallel to the longitudinal direction and arranged on either side of a free space (70), a transverse avionics rack (102) supported by the transverse chassis (80) located to the rear of the two longitudinal rows of avionics racks (68, 68').
